(19) Europäisches Patentamt
European Patent Office
Office européen des brevets

(11) Veröffentlichungsnummer : **0 420 002 B1**

# (12) EUROPÄISCHE PATENTSCHRIFT

(45) Veröffentlichungstag der Patentschrift : **13.12.95 Patentblatt 95/50**

(51) Int. Cl.$^6$ : **G03G 5/05**

(21) Anmeldenummer : **90117904.4**

(22) Anmeldetag : **18.09.90**

## (54) Elektrophotographisches Aufzeichnungsmaterial

(30) Priorität : **27.09.89 DE 3932160**

(43) Veröffentlichungstag der Anmeldung : **03.04.91 Patentblatt 91/14**

(45) Bekanntmachung des Hinweises auf die Patenterteilung : **13.12.95 Patentblatt 95/50**

(84) Benannte Vertragsstaaten : **DE FR GB NL**

(56) Entgegenhaltungen : **PATENT ABSTRACTS OF JAPAN, vol. 11, no. 248 (P-604)(2695), 13. August 1987 (CANON INC.) 11. März 1987 & JP-A-62 55 663**
**JAPANESE PATENTS GAZETTE, Week 7811, 24. April 1978, Derwent Publications Ltd., London, GB ; AN 78-20690 A (11) ; & JP-A-53 012 623**

(73) Patentinhaber : **HOECHST AKTIENGESELLSCHAFT**
**D-65926 Frankfurt am Main (DE)**

(72) Erfinder : **Müller-Hess, Waltraud, Dr. Dipl.-Chem.**
**Lärchenstrasse 4**
**D-6200 Wiesbaden (DE)**
Erfinder : **Mohr, Dieter, Dr. Dipl.-Chem.**
**Eaubonner Strasse 8**
**D-6501 Budenheim (DE)**
Erfinder : **Kroggel, Matthias, Dr. Dipl.-Chem.**
**Am Flachsland 15**
**D-6233 Kelkheim (DE)**

**EP 0 420 002 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

## Beschreibung

Die Erfindung betrifft ein elektrophotographisches Aufzeichnungsmaterial aus einem elektrisch leitenden, insbesondere zur Herstellung einer Druckform oder einer gedruckten Schaltung geeigneten Schichtträger und einer photoleitfähigen Schicht aus Photoleiter , hochmolekularem, in wäßrig alkalischer oder alkoholischer Lösung löslichem oder dispergierbarem Bindemittel, Sensibilisator und/oder Aktivator und üblichen Zusätzen.

Es ist bekannt, zur Herstellung von Druckformen oder gedruckten Schaltungen auf elektrophotographischem Wege photoleitfähige Schichten aus monomeren oder polymeren organischen Photoleitern, Sensibilisatoren und/oder Aktivatoren sowie alkalilöslichen Bindemitteln auf entsprechenden Schichtträgern einzusetzen (DE-PS 11 17 391 entsprechend GB-PS 944 126). Die photoleitfähigen Schichten werden durch geeignete Beschichtungstechniken aus Lösung oder durch Laminieren (DE-OS 30 24 772 entsprechend US-PS 4 492 747) auf einen metallischen oder metallisierten Schichtträger aufgebracht. Das hochmolekulare Bindemittel enthält dabei alkalilöslichmachende Gruppen wie Säureanhydrid-, Carboxyl-, Phenol-, Sulfon-, Sulfonamid- oder Sulfonimid-Gruppen (DE-PS 23 22 047 entsprechend US-PS 4 066 453). Als Bindemittel werden Mischpolymerisate aus Styrol und Maleinsäureanhydrid, Phenolharze oder Mischpolymerisate aus Styrol, Methacryl- oder Acrylsäure und Methacrylsäureester besonders erwähnt.

Zur Herstellung einer Flachdruckform wird das elektrophotographische Aufzeichnungsmaterial elektrostatisch aufgeladen, belichtet oder bildmäßig elektrostatisch aufgeladen und mit einem Toner eines Trocken- oder Flüssigentwicklers entwickelt. Das entstandene Tonerbild wird durch Erwärmen auf 100 bis 250 °C fixiert und die Schicht wird dann zur Entschichtung mit einer alkalisch-wäßrigen oder alkoholischen Lösung behandelt, wodurch die nicht vom Toner bedeckten Stellen weggelöst werden. Analog erhält man eine Maske für eine gedruckte Schaltung.

Bei der Herstellung einer gedruckten Schaltung auf elektrophotographischem Wege nach bekannten Verfahren besteht der Nachteil darin, daß man die Schichten mit dem alkalilöslich machenden Bindemittel entweder gar nicht oder nur bei relativ hoher Temperatur auf eine Kupfer-kaschierte Leiterplatte aufbringen bzw. laminieren kann. Die hohe Temperatur erschwert den Laminerprozeß und führt leicht zu einer Schädigung der meist thermoempfindlichen Photoleitersubstanzen, Sensibilisatoren und Aktivatoren. Die photoleitfähige Schicht verliert dadurch an Photoempfindlichkeit. Ein anderer Nachteil liegt darin, daß die für den elektrophotographischen Prozeß verwendeten Schichten mit den bekannten alkalilöslichen Bindemitteln in größeren Schichtdicken von etwa 30 µm Stärke, wie sie für die Herstellung von Leiterplatten nötig sind, nicht mehr flexibel genug sind. Man muß deshalb diese Schichten mit äußerster Vorsicht handhaben, da schon ein leichtes Knicken zu einer unerwünschten Rißbildung führt und die Schicht dadurch unbrauchbar wird.

Bei der Herstellung einer Druckform oder einer gedruckten Schaltung auf elektrophotographischem Wege müssen der Entschichterlösung zur Erhöhung der Prozeßgeschwindigkeit Lösungsmittel zugesetzt werden. Diese lösungsmittelhaltigen Entschichterlösungen haben einen entsprechenden Geruch, der von manchen Verarbeitern bemängelt wird, da er besonders beim Reinigen des Entschichtergerätes stört.

Ein weiterer Nachteil der bekannten alkalilöslichen Bindemittel ist die besonders bei großer Schichtdicke auftretende Verschlechterung der elektrophotographischen Empfindlichkeit.

Es war deshalb Aufgabe der vorliegenden Erfindung ein elektrophotographisches Aufzeichnungsmaterial für die Herstellung einer Druckform oder einer gedruckten Schaltung zu schaffen, dessen photoleitfähige Schicht gut laminierbar und flexibel ist, eine gute Aufladbarkeit besitzt und dennoch selbst bei relativ großen Schichtdicken eine hohe Empfindlichkeit bietet und leicht und schnell in einem möglichst umweltfreundlichen, wäßrigalkalischen Entschichter löslich ist.

Die Lösung dieser Aufgabe geht aus von einen elektrophotographischen Aufzeichnungsmaterial der eingangs genannten Art und ist dadurch gekennzeichnet, daß in der photoleitfähigen Schicht als Bindemittel ein Pfropfmischpolymerisat mit einem Polyurethan als Pfropfgrundlage mit aufgepfropften Ketten vorhanden ist, die Vinylalkoholeinheiten enthalten. Vorzugsweise enthalten die aufgepfropften Ketten ferner freie Vinylester- bzw. Vinylacetaleinheiten und zwecks Erhöhung der Alkalisierbarkeit Carboxyl- und/oder Sulfonylurethangruppen.

Die Vinylacetaleinheiten sind von einen aliphatischen oder cycloaliphatischen Aldehyd abgeleitet. Die aufgepfropften Ketten können ferner Einheiten von weiteren ethylenisch ungesättigten, mit Vinylestern copolymerisierbaren Monomeren enthalten.

Pfropfpolymerisate, die aus einen Polyurethan als Pfropfgrundlage und aufgepfropften Vinyleinheiten bestehen, die mindestens teilweise zu Vinylalkoholeinheiten verseift sind, sind aus DE-A 37 32 089 bekannt. Sie werden als Bindemittel für Pigmente, zur Herstellung von Druckfarben, von Schmelzklebern, von lösungsmittelhaltigen Klebstoffen, als Bestandteil von Lacken oder Beschichtungsmitteln für Fasern, Folien, Metalle und für thermoplastische Formkörper eingesetzt. Aus der älteren deutschen Patentanmeldung, Aktenzeichen P 38 35 840.9 werden Pfropfmischpolymerisate beschrieben, die aus den vorstehend genannten Pfropfpolymerisaten durch Acetalisieren mit Aldehyden erhalten wurden. Zu ihrer Herstellung wird auf eine Pfropfgrundlage aus einen Polyurethan ein Carbonsäurevinylester und ggf. eine weitere damit copolymerisierbare ethylenisch ungesättigte Verbindung aufgepfropft und danach ganz oder teilweise verseift. Die dabei erhaltenen Polymeren mit Vinylalkoholeinheiten können weiter mit Aldehyden zu Polyvinylacetalen umgesetzt werden.

Der Mengenanteil der aufgepfropften Komponenten beträgt im allgemeinen 10 bis 95, vorzugsweise 30 bis 90 und insbesondere 40 bis 80 Gew.-%, bezogen auf das gesamte Pfropfpolymerisat.

Die erfindungsgemäß als Bindemittel verwendeten Polymerisate enthalten 10 bis 80 Mol-Prozent freie Hydroxylgruppen, 1 bis 65 Mol-Prozent Acylgruppen, 0 bis 85 Mol-Prozent Acetalgruppen, 0 bis 40 Mol-Prozent Carboxylgruppen und 0 bis 40 Mol-Prozent Sulfonylurethangruppen.

Carboxylgruppen werden in die Pfropfpolymeren durch Umsetzung von freien Hydroxylgruppen mit intramolekularen Anhydriden organischer Polycarbonsäuren eingeführt.

Das Säureanhydrid leitet sich bevorzugt von einer Di- oder Tricarbonsäure insbesondere einer Dicarbonsäure, ab und kann einen, zwei oder mehrere Ringe enthalten.

Besonders bevorzugte Bindemittel werden durch Umsetzen mit Säureanhydriden einer der Formeln I, II oder III

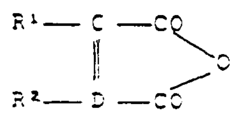 (I)

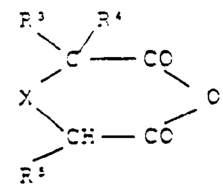 (II)

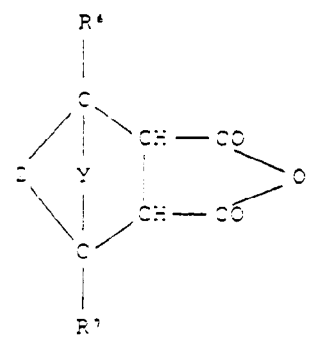 (III)

erhalten, worin

$R^1$ und $R^2$ einzeln Wasserstoffatome oder Alkylgruppen bedeuten oder miteinander zu einem aromatischen oder heteroaromatischen, gegebenenfalls substituierten und gegebenenfalls teilweise hydrierten 5- oder 6-gliedrigen Ring verbunden sind, an den bis zu zwei aromatische oder cycloaliphatische Ringe ankondensiert sein können,

$R^3$, $R^4$ und $R^5$ einzeln Wasserstoffatome oder Alkylgruppen bedeuten oder

$R^3$ und $R^5$ miteinander zu einem gegebenenfalls substituierten gesättigten oder ungesättigten aliphatischen Ring verbunden sind, der einschließlich X fünf oder sechs Ringglieder haben kann,

$R^6$ und $R^7$ Wasserstoffatome oder Alkylgruppen,

X eine Einfachbindung, eine 1,1-Alkylengruppe, eine 1,1-Cycloalkylengruppe, die gegebenenfalls substituiert sind, ein Sauerstoff- oder Schwefelatom,

Y ein Sauerstoff- oder Schwefelatom, eine 1,1- oder 1,2-Alkylengruppe oder eine 1,2-Alkylengruppe, an die gegebenenfalls ein aromatischer oder cycloaliphatischer Ring ankondensiert ist, und

Z die zur Vervollständigung eines gesättigtern oder ungesättigten gegebenenfalls substituierten Ringes erforderlichen Ringglieder bedeuten, wobei an diesen Ring bis zu zwei aromatische oder cycloaliphatische Ringe ankondensiert sein können.

Wenn $R^1$, $R^2$, $R^3$, $R^4$, $R^5$, $R^6$ oder $R^7$ Alkylgruppen bedeuten, haben diese im allgemeinen 1 bis 4, bevorzugt 1 bis 2 Kohlenstoffatome. Substituenten, die an die aromatischen oder cycloaliphatischen Ringe verbunden sein können, sind z.B. Alkylgruppen, Alkoxygruppen, Halogenatome, Nitrogruppen oder Carboxylgruppen.

Beispiele für geeignete Säureanhydride sind:

Maleinsäureanhydrid und Derivate,
z.B. Dimethylmaleinsäureanhydrid oder Citraconsäureanhydrid,
Bernsteinsäureanhydrid und Derivate,
z.B. Methylbernsteinsäureanhydrid,
Glutarsäureanhydrid und Derivate,
z.B. 3-Methylglutarsäureanhydrid, 3,3-Tetramethylenglutarsäureanhydrid oder Camphersäureanhydrid,
3-Oxa-glutarsäureanhydrid und Derivate, Phthalsäureanhydrid und Substitutionsprodukte,
z.B. Chlor-, Nitro- oder Carboxyphthalsäureanhydrid,
teilweise oder vollständig hydrierte Phthalsäureanhydride,
z.B. Hexahydrophthalsäureanhydrid oder Cyclohexen-1,2-dicarbonsäureanhydrid,
Naphthalin-2,3-dicarbonsäureanhydrid oder Naphthalin-1,8-dicarbonsäureanhydrid und deren Substitutionsprodukte,
Pyridin-o-dicarbonsäureanhydrid und dessen Substitutionsprodukte,
Pyrazin-o-dicarbonsäureanhydrid und dessen Substitutionsprodukte,
Furan-o-dicarbonsäureanhydrid oder Furan-2,5-dicarbonsäureanhydrid, deren Substitutionsprodukte sowie deren teilweise oder vollständig hydrierte Derivate,
Thiophen-o-dicarbonsäureanhydrid oder Thiophen-2,5-dicarbonsäureanhydrid, deren Substitutionsprodukte sowie deren ganz oder teilweise hydrierte Derivate,
di- oder polycyclische Anhydride, die durch Diels-Alder-Reaktion eines Diens mit Maleinsäureanhydrid entstehen,
z.B. die Additionsprodukte aus Furan, Anthracen, Cyclohexadien-1,3 oder Cyclopentadien und Maleinsäueanhydrid.

Bevorzugt werden die Reaktionsprodukte mit Malein-, Phthal-, Bernstein- oder 3-Oxa-glutarsäureanhydrid.

Die Sulfonylurethangruppen werden durch Umsetzung von freien OH-Gruppen im Pfropfpolymer mit Sulfonylisocyanaten der allgemeinen Formel $R\text{-}SO_2\text{-}NCO$ eingeführt. R kann ein Alkyl- oder Alkoxyrest mit 1 bis 6 C-Atomen, ein aliphatischer oder cycloaliphatischer Rest mit mindestens einer olefinischen Doppelbindung sein. In diesem Fall enthält R im allgemeinen 2 bis 12 C-Atome.

Wenn R eine Alkenylgruppe ist, hat diese bevorzugt 2 bis 4 Kohlenstoffatome; als Cycloalkenylgruppen werden solche mit 5 bis 8 Kohlenstoffatomen bevorzugt. Beispiele sind Vinyl-, Propenyl-, Allyl-, 1-Butenyl-(4)-, Cyclohex-3-en-1-yl-, Cyclohex-1-en-1-yl-, Methyl-cyclohex-3-en-1-yl und dgl. mehr. Besonders bevorzugt werden Propenyl- und Cyclohexenyl-Reste.

R kann auch ein Phenylrest sein, der durch Alkylreste mit bis zu 3 C-Atomen substituiert sein kann. Besonders bevorzugt wird das p-Toluolsulfonylisocyanat.

Sulfonylurethangruppen werden bevorzugt durch Umsetzung eines Polyvinylalkoholpfropfpolymerisates mit Propenylsulfonylisocyanat und p-Toluolsulfonylisocyanat eingeführt.

Die Einführung der Sulfonylurethan- und/oder Carboxylgruppen in das Pfropfmischpolymer kann unmittelbar im Anschluß an die Verseifung der Carbonsäureestergruppen des Ausgangspfropfpolymerisats oder nach einer Acetalysierung stattfinden.

Als Bindemittel finden vollverseifte Derivate, teilverseifte Derivate und die jeweiligen Acetalisierungsprodukte mit $C_1$ bis $C_{20}$-Aldehyden Einsatz; sie enthalten bevorzugt zusätzlich 2 bis 40 Mol-Prozent Sulfonylurethan- und/oder Carboxylgruppen. Die Einführung dieser Alkalilöslichkeit vermittelnden Gruppen ist zwar bevorzugt, jedoch nicht unbedingt erforderlich.

Durch den erfindungsgemäßen Einsatz der Derivate der Polyvinylalkohol-Pfropfpolymeren als Bindemittel in den elektrophotographischen Aufzeichnungsschichten werden Druckformen oder gedruckte Schaltungen mit vorteilhaften, teilweise überraschend verbesserten Eigenschaften erhalten.

Die erfindungsgemäß verwendeten Bindemittel übertreffen aufgrund von zwei strukturellen Besonderheiten herkömmliche, alkalisch entwickelbare Bindemittel in elektrophotographischen Aufzeichnungsmaterialien.

Die den herkömmlichen Polyvinylalkoholen eigene Sprödigkeit wird in den erfindungsgemäßen Pfropfpolymeren durch Ethergruppen in der Polymerhauptkette erheblich zurückgedrängt. Diese Ethergruppen bewirken außerdem eine verbesserte Löslichkeit in wäßrig alkalischen Entwicklerlösungen. Die erhöhte Elastizität der Pfropfpolymeren wird von den ebenfalls ins Backbone eingebauten Urethangruppen unterstützt.

Die Sprödigkeit der auf Polyurethanbasis aufgepfropften Polyvinylalkoholderivate ist gegenüber herkömmlichen Polyvinylalkoholen deutlich abgesenkt. Dadurch werden auch bei Schichtdicken von etwa 30 µm Stärke flexible Platten erhalten. Die Schmelzpunkte der Polymerisate sind durch Zusammensetzung der Polyurethanpfropfgrundlage als auch durch den Verseifungsgrad und die Derivatisierung der entstandenen OH-Gruppen sehr breit variierbar.

In den zur Herstellung der erfindungsgemäßen Bindemittel verwendeten Pfropfpolymeren beträgt der prozentuale Anteil der aufgepfropften Komponenten 10 bis 95, vorzugsweise 30 bis 90 insbesondere 40 bis 80 Gewichtsprozent, bezogen auf das Gesamtpfropfpolymerisat.

Die Polyurethan-Pfropfgrundlagen bestehen aus Polyurethanen mit mindestens 2 Urethangruppen im Molekül, wobei die Anzahl der Urethangruppen pro Pfropfgrundlagenmolekül nach oben keiner besonderen Begrenzung unterliegt und im allgemeinen höhere Werte als 2 annehmen kann.

Die als Pfropfgrundlage eingesetzten Polyurethane lassen sich nach üblichen Verfahren der Polyurethansynthese aus Diolen und Diisocyanaten herstellen. Prinzipiell sind alle bei der Polyurethansynthese üblicherweise verwendeten Diole einsetzbar. Bevorzugt werden cycloaliphatische Diole, z.B. solche mit 5 - 10 Kohlenstoffatomen, wie Cyclohexandiole, sowie insbesondere aliphatische Diole mit 2 bis 12 C-Atomen. Bevorzugt werden ferner Polyetherdiole, z. B. Polypropylenoxide, Polybutylenoxide, Mischpolymere aus Ethylenoxid, Propylenoxid, Butylenoxid, vorzugsweise deren Blockcopolymere; besonders bevorzugt werden Polyethylenoxide, insbesondere solche mit Molekulargewichten zwischen 200 und 10 000, insbesondere zwischen 400 und 1500. Die Polyetherdiole werden mit Vorteil in Kombination mit niedermolekularen aliphatischen Diolen, z. B. 1,4-Butandiol, 1,3-Propandiol, Ethylenglykol, Diethylenglykol, 1,2-Hexandiol, Pentandiol oder Cyclohexandiol eingesetzt. Bevorzugt liegt ein molares Verhältnis von Polyetherdiol zu niedermolekularem aliphatischem Diol von 1 : 0,1 bis 1 : 0,7 vor.

Als Diisocyanatkomponenten werden aromatische, bevorzugt alipahtische und/oder cycloaliphatische Diisocyanate eingesetzt.

Besonders bevorzugt ist die Verwendung von 1,6-Hexamethylendiisocyanat und/oder Isophorondiisocyanat.

Die Molverhältnisse von Diol- zu Diisocyanatkomponenten liegen vorzugsweise zwischen 1 : 0,99 und 1 : 0,5, insbesondere zwischen 1 : 0,89 und 1 : 0,7. Die mittleren Molekulargewichte der Polyurethane liegen vorzugsweise zwischen 200 und 100 000, insbesondere zwischen 1 000 und 50 000, besonders bevorzugt zwischen 3 000 und 25 000.

Zur Pfropfung auf die Polyurethan-Pfropfgrundlagen werden bevorzugt Vinylcarbonsäureester mit 3 bis 20 C-Atomen eingesetzt. Bevorzugt wird Vinylacetat und/oder Vinylpropionat aufgepfropft.

Weiterhin können die Vinylcarbonsäureester auch zusammen mit anderen ethylenisch ungesättigten und copolymerisierbaren Monomeren, wie z.B. Maleinsäure, Itaconsäure, Mesaconsäure, Crotonsäure, Acrylsäure oder deren Estern, gepfropft werden.

Die Pfropfung wird unter Verwendung von Radikalketten startenden Pfropfkatalysatoren durchgeführt.

Die erhaltenen Pfropfpolymerisate lassen sich durch Hydrolyse, Alkoholyse oder Umesterung in teil- oder vollverseifte Produkte überführen, wobei der Hydrolysegrad mindestens 30, vorzugsweise 45 bis 99 Mol-Prozent, bezogen auf die Molzahl verseifbarer Monomereinheiten im Pfropfpolymerisat, beträgt.

Die erhaltenen Pfropfpolymerisate lassen sich nach Entfernen der Restmonomeren (meist durch azeotrope Destillation mit Methanol) durch Eintragen der Mischung in Wasser in ihrer unverseiften Form ausfällen. Sie können aber auch nach Verdünnung mit einem Lösungsmittel, vorzugsweise mit Methanol, mittels saurer Katalysatoren (z.B. Salzsäure, Phosphorsäure, p-Toluolsulfonsäure etc.) oder aber vorzugsweise unter Verwendung alkalischer Katalysatoren (z.B. NaOH, KOH, $NaOCH_3$, $KOCH_3$, etc.) gegebenenfalls unter Verwendung von Wasser nach üblichen literaturbekannten Verfahren in teil- bzw. vollverseifte Produkte übergeführt werden.

In diese teil- oder vollverseiften Pfropfpolymerisate werden durch die bereits erwähnten Reaktionen Carboxyl- oder Sulfonylurethangruppen eingeführt. Andererseits können die voll- oder teilverseiften Pfropfpolymerisate auch vor Einführung der Alkalilöslichkeit erhöhenden Gruppen acetalisiert werden.

Die Acetalisierung der voll- oder teilverseiften Pfropfpolymerisate läßt sich nach literaturbekannten Verfahren bevorzugt im sauren Medium, durchführen.

Zur Acetalisierung werden $C_1$- bis $C_{20}$-Aldehyde, die aliphatisch, geradkettig oder verzweigt und substituiert sein können, und aromatische Aldehyde, die ebenfalls substituiert sein können, eingesetzt. Bevorzugt werden n-Butyraldehyd, Isobutyraldehyd, Propionaldehyd oder Formaldehyd, Benzaldehyd, p-Chlorbenzaldehyd, p-Methoxybenzaldehyd und Kombinationen dieser Aldehyde untereinander verwendet.

Der Acetalisierungsgrad der Pfropfpolyvinylacetale liegt vorzugsweise in einem solchen Bereich, daß der Gehalt an nicht acetalisierten Polyvinylalkoholeinheiten in den Pfropfpolyvinylacetalen bevorzugt größer als 15 Mol-Prozent ist, insbesondere 18 bis 60 und ganz besonders bevorzugt 20 bis 45 Mol-Prozent, jeweils bezogen auf den molaren Gehalt (= 100 Mol-Prozent) an Vinylalkoholeinheiten in den Ausgangspfropfpolyvinylalkoholen vor der Acetalisierung, beträgt, wobei 45 Mol-Prozent in der ursprünglichen, veresterten Form vorliegen können, d.h. insbesondere in Form von Acetyl- oder Propionylgruppen.

Die Einführung von Carboxyl- und/oder Sulfonylurethangruppen in die Derivate des Polyvinylalkoholpfropfpolymerisats kann durch Umsetzung von freien Hydroxylgruppen im Polymerisat mit Carbonsäureanhydriden mehrbasischer Säuren bzw. Sulfonylisocyananten in jeder beliebigen und bekannten Art und Weise erfolgen.

Die Umsetzung mit Säureanhydriden kann beispielsweise in Ketonen, z.B. Butanon, Tetrahydrofuran, Dioxan oder N-Methylpyrrolidon durchgeführt werden. Als Katalysatoren werden zweckmäßig tertiäre Amine eingesetzt. Im allgemeinen werden auf 100 Gewichtsteile Hydroxylgruppen enthaltendes Polymerisat 0,5 bis 80 Gewichtsteile Anhydrid, 1000 bis 3000 Gewichtsteile Lösungsmittel und 0,5 bis 5 Gewichtsteile tertiäres Amin verwendet. Die Reaktion kann in Lösung oder in heterogener Phase durchgeführt werden.

Eine typische Reaktion in homogener Phase verläuft folgendermaßen:

Das hydroxylgruppenhaltige voll- oder teilverseifte und gegebenenfalls acetalisierte Pfropfpolymerisat wird zunächst in einem geeigneten, wasserfreien Lösungsmittel, gegebenenfalls in der Wärme, gelöst. Zu dieser Lösung wird ein basischer Katalysator, bevorzugt Dimethylaminopyridin und/oder Triethylamin, gegeben und mit der erforderlichen Menge Anhydrid versetzt. Die Mischung wird bei Temperaturen zwischen 50 und 120 °C etwa 5 bis 10 Stunden gerührt. Die erkaltete Lösung des Bindemittels ist dann gebrauchsfertig und kann in den vorgegebenen Beschichtungslösungen eingesetzt werden.

Für manche Anwendungen kann es erforderlich sein, daß das Polymer in fester Form isoliert wird. Zu diesem Zweck tropft man die Reaktionslösung in eine größere Menge eines geeigneten Nichtlösers, insbesondere Wasser. Das ausgefallene Polymer wird abgesaugt und getrocknet.

Die Umsetzung mit Sulfonylisocyanaten kann prinzipiell in denselben Lösungs- und Dispergiermitteln durchgeführt werden wie die Umsetzung mit Carbonsäureanhydriden. Die Reaktionsführung kann in jeder beliebigen und bekannten Art und Weise erfolgen. Vorteilhafter Weise wird das Polymerisat in einem inerten Lösungs- oder Dispergiermittel gelöst oder dispergiert und mit einem Katalysator versetzt. Als Katalysatoren finden tertiäre Amine oder Zinnverbindungen, wie Dibutylzinndilaurat, Verwendung. Zu diesen Lösungen oder Dispersionen wird das entsprechende Sulfonylisocyanat, gegebenenfalls in gelöster Form, zugetropft. Dabei erwärmt sich das Reaktionsgemisch bisweilen; zur Vervollständigung der Reaktion wird das Gemisch ca. 2 bis 24 Stunden auf Temperaturen zwischen 20 und 120 °C erwärmt. Der vollständige Ablauf der gewünschten Reaktion wird durch Überprüfung des Gehalts an freiem Sulfonylisocyanat bestimmt. Nach Vervollständigung der Umsetzung kann die Lösung direkt zur Herstellung von Beschichtungslösungen verwendet werden; das Polymer kann aber auch für bestimmte Anwendungen als Feststoff isoliert werden, beispielsweise durch Eintropfen der Reaktionslösung in einen Nichtlöser. Bei einer heterogenen Reaktionsführung wird das Polymer durch Absaugen und mehrmaliges Auswaschen mit dem Nichtlöser gereinigt. Werden Carboxyl- und Sulfonylurethangruppen ins Polymerisat eingebracht, so wird bevorzugt die Umsetzung mit dem Sulfonylisocyanat vor der Umsetzung mit dem Anhydrid vorgenommen. Die Reaktionen werden nacheinander, ohne zwischenzeitliche Isolierung des Polymerisats durchgeführt.

Die mit den erfindungsgemäß eingesetzten Bindemitteln erhaltenen elektrophotographischen Aufzeichnungsmaterialien zeichnen sich durch eine hohe Flexibilität und Laminierfähigkeit auch bei hohen Schichtgewichten, durch eine hervorragende Aufladbarkeit und Empfindlichkeit, durch eine hohe Druckauflage und durch die leichte wäßrig alkalische Entschichtbarkeit aus. Sie werden insbesondere zur Herstellung von elektrophotographischen Druckformen verwendet.

Die elektrophotographischen Schichten enthalten bei derartigen Anwendungen im allgemeinen 80 bis 40, bevorzugt 65 bis 50 Gewichtsprozent der vorbeschriebenen Bindemittel.

Andererseits, so wurde gefunden, können Bindemittelgemische verwendet werden, wobei etwa 10 Gewichtsprozent des erfindungsgemäßen Pfropfmischpolymerisats vorhanden sind und bis zu 90 Gewichtsprozent der Gesamtmenge an Bindemittel durch eine Vielzahl herkömmlicher Bindemittel ersetzt werden kann. Die anderen Polymerbindemittel müssen dabei ebenfalls in wäßrig-alkalischen Lösungen löslich, dispergierbar oder mindestens quellbar sein und mit den erwähnten Pfropfpolyvinylalkohol-Derivaten weitgehend verträglich sein. Dies bedeutet, daß man aus den Komponenten eine homogene Mischung herstellen kann, die für den Einsatz in elektrophotographischen Aufzeichnungsmaterialien geeignet ist.

Als herkömmliche Bindemittel seien genannt: Polyesterharze wie z.B. Mischpolyester aus Iso- und Terephthalsäure mit Glykol. Auch Silikonharze wie dreidimensional vernetzte Phenyl-methyl-siloxane oder sogenannte Reaktivharze wie sie unter der Bezeichnung DD-Lacke bekannt sind, haben sich als geeignet erwiesen. Ferner sind Mischpolymerisate aus Styrol und Maleinsäureanhydrid, aber auch Polycarbonatharze, Alkylmethacrylat/Methacrylsäure-Mischpolymerisate und Mischpolymerisate aus Methacrylsäure, höheren Alkylmethacrylaten und Methylmethacrylat und/oder Styrol geeignet.

Als Schichtträgermaterialien für die Photoleiterschichten werden je nach Anwendungsgebiet Metallfolien oder -platten, oberflächlich leitfähig gemachte Kunststoffolien oder gegen das Eindringen von Lösungsmitteln speziell präparierte, leitfähig gemachte Kunststoffolien eingesetzt, wenn ein elektrophotographisches Filmmaterial hergestellt werden soll. Findet das erfindungsgemäße Gemisch Verwendung auf dem Gebiet der Bürokopie, so wird Papier als Schichtträger eingesetzt.

Findet das erfindungsgemäße Gemisch Einsatz bei der Herstellung von Druckformen, so werden metallische Schichtträger, insbesondere Aluminium, eingesetzt. Die verwendeten Aluminiumfolien werden zweckmäßigerweise mechanisch oder elektrochemisch oberflächlich aufgerauht und in besonderen Fällen anodisiert. Als Schichtträger für die photoleitfähige Schicht zur Herstellung gedruckter Schaltungen oder geätzter Formteile dienen insbesondere kupferkaschierte Epoxyharzplatten, kupferkaschierte Polyimidfolien oder dünne Metallfolien. Die photoleitfähige Schicht kann auch laminierbar auf einem Zwischenträger aus Polyesterfolie aufgebracht sein.

Als organische Photoleiter kommen monomere wie polymere aromatische wie heterocyclische Verbindungen in Frage. Als Monomere werden besonders heterocyclische Verbindungen wie Oxazol-Derivate, die in der deutschen Patentschrift 10 58 836 entsprechend US-PS 3 189 447 genannt sind, eingesetzt. Hierzu gehören insbesondere das 2,5-Bis-(p-diethylaminophenyl)-oxdiazol-1,3,4. Weitere geeignete monomere photoleitende Verbindungen sind zum Beispiel Triphenylaminderivate, höher kondensierte aromatische Verbindungen wie Anthracen, benzokondensierte Heterocyclen, Pyrazolin- oder Imidazolderivate, hierher gehören auch Triazol- sowie Oxazolderivate, wie sie in den deutschen Patentschriften 10 60 260 bzw. 11 20 875 entsprechend US-PS 3 112 197 bzw. US-PS 3 257 203, offenbart sind.

Als polymere Photoleiter sind beispielsweise vinylaromatische Polymere wie Polyvinylanthracen, Polyacenaphthylen oder Mischpolymerisate geeignet. Ganz besonders bewährt haben sich Poly-N-vinylcarbazol oder Mischpolymerisate des N-Vinylcarbazols mit einem N-Vinylcarbazolgehalt von mindestens etwa 40 %.

Zur Erweiterung des spektralen Empfindlichkeitsbereiches ist es bekannt, Sensibilisatoren in der photoleitfähigen Schicht zu verwenden. Als Sensibilisierungsfarbstoffe, gekennzeichnet durch den Color Index (C.I.), 3. Aufl. 1971, London, aus der Reihe der Triarylmethanfarbstoffe sind u.a. geeignet: Brillantgrün (C.I. 42040), Victoriablau B (C.I. 44045), Methylviolett (C.I. 42535), Kristallviolett (C.I.42555), Säureviolett 6BN(C.I.42552), Malachitgrün (C.I.42000), Fanalblau RM (C.I.42600), Chromoxanreinblau B (C.I.43830), Naphthalingrün V (C.I.44025) und Wollechtblau FGL (C.I.44505).

Aus der Reihe der Xanthenfarbstoffe sind u.a. geeignet: Rhodamin B (C.I. 45170), Rhodamin 6G (C.I.45160), Sulforhodamin B (C.I.45100), Eosin B (C.I.45430), Cyanosin (C.I.45410), Rose Bengale (C.I.45440) oder Fluorescein (C.I.45350).

Aus der Reihe der Polymethinfarbstoffe kommen u.a. in Frage: Astrazongelb 3G (C.I.48055), Astrazongelb 5G (C.I. 48065), Basic Yellow 52115 (C.I. 48060), Astrazongelb GRL (C.I. Basic Yellow 29), Astrazongelb 7GLL (C.I. Basic Yellow 21), Astragelb R (C.I. Basic Yellow 44), Astrazonorange G (C.I. 48035), Astrazonorange R (C.I. 48040) und Astrazonorange 3R (C.I. Basic Orange 27).

Weiterhin kommen Thiazinfarbstoffe, wie Methylenblau (C.I. 52015), Acridinfarbstoffe, wie Acridingelb (C.I. 46025), Acridinorange (C.I. 46005) und Trypaflavin, Chinolinfarbstoffe, Chinon- und Ketonfarbstoffe als Sensibilisierungsfarbstoffe in Frage.

Viele dieser Farbstoffe zeigen in der angegebenen Form eine Vorbelichtungsempfindlichkeit, d.h. die mit ihnen sensibilisierten Schichten lassen sich nach einer ca. 12stündigen Lagerung im Dunkeln deutlich höher aufladen, als nach einer, wenn auch nur kurzfristigen Belichtung. Um diese unerwünschte Eigenschaft zu reduzieren oder zu vermeiden, kann ein anderes Farbstoffsalz eingesetzt werden. So läßt sich die beschriebene Vorbelichtungsempfindlichkeit bei kationischen Farbstoffen, z.B. Rhodamin B, vermeiden, wenn statt des Chloridanions, das Perchlorat- oder das Fluorboratanion, z.B das Tetrafluorboratanion, durch Umfällen eingeführt wird. Weitere Anionen sind z.B. p-Tosyl oder das Fluorphosphatanion, z.B. das Hexafluophosphat und andere mehr.

Alle Farbstoffe können allein oder auch in Mischungen verwendet werden. Auch eine Aktivierung mit Elektronenakzeptoren ist möglich und zum Beispiel in DE-OS 27 26 116 beschrieben. Geeignete Akzeptoren sind: Nitrofluorenon, Trinitrofluorenon, Dicyanomethylenfluoren, Dicyanomethylendinitrofluorenon, Dicyanomethylenpolynitrofluorenon und 3,6-Dinitronaphthalin-1,8-dicarbonsäureanhydrid.

Daneben ist eine Sensibilisierung mit dispergierten photoleitfähigen Farbstoffpigmenten möglich, wie zum Beispiel in DE-OS 21 08 939 entsprechend US-PS 3 870 516 beschrieben ist. Hier können auch anorganische Photoleiter, wie gasförmiges Selen, Selenlegierungen, Kadmium-sulfidsulfoselenid, Zinkoxid oder Phthalocyanin, auch metallhaltig, und andere Farbstoffpigmente, wie Perylenpigmente etwa N,N′-Diemthylperylentetracarbonsäurediimid verwendet werden. Diese dispergierbaren Farbstoffpigmente werden vorzugsweise in einer Konzentration von 0,5 bis 2% eingesetzt und führen zu vorbelichtungsunempfindlichen photoleitfähigen Schichten.

Das Mischungsverhältnis der Sensibilisierungsfarbstoffe zueinander ist variabel und abhängig zum Beispiel von der in der Kamera anwesenden Lichtquelle, von dem Absorptionsbereich des verwendeten Photoleiters und der Art des jeweiligen Sensibilisators. Das Verhältnis kann deshalb in weiten Grenzen schwanken. Durch bestimmte Mischung kann etwa der Spektralbereich der photoleitfähigen Schicht dem in der Kamera

angewandten Lampentyp angepaßt werden. Für den Einsatz der gebräuchlichen Halogen-Wolfram-Lampen ist unter Berücksichtigung der zunehmenden Emission dieser Lampen im roten Spektralbereich eine solche Photoleiterschicht vorteilhaft, die eine im kurzwelligen Spektralbereich höhere bzw. ansteigende Empfindlichkeit aufweist.

Obgleich das Mischungsverhältnis der Farbstoffe nicht kritisch ist, werden im allgemeinen Sensibilisierungsgemische mit etwa 25 bis 90 Gewichtsprozent, bezogen auf das Farbstoffgemisch, an Polymethinfarbstoff bevorzugt.

Der Gewichtsanteil an Sensibilisierungsfarbstoffgemisch in der photoleitfähigen Schicht kann ebenfalls unterschiedlich sein und richtet sich in wesentlichen nach der erwünschten bzw. geforderten Empfindlichkeit. Die Gewichtsmenge an Farbstoffgemisch wird im allgemeinen zwischen etwa 0,5 und etwa 0,001 %, bezogen auf den Photoleiter, schwanken.

Das erfindungsgemäße Aufzeichnungsmaterial kann als übliche Zusätze in der photoleitfähigen Schicht Verlaufsmittel und Weichmacher und/oder Zwischenschichtträger und Schichthaftvermittler enthalten.

Die Entschichtung erfolgt bevorzugt mit wäßrig-alkalischen Entschichterlösungen. Gegebenenfalls können die Entschichter Zusätze enthalten, die zu einem beschleunigten, praxisgerechten Entschichtungsvorgang beitragen. Als für diesen Zweck geeignete Zusätze seien insbesondere Tenside erwähnt. Die Zusammensetzung geeigneter Entschichterlösungen für die erfindungsgemäßen lichtempfindlichen Schichten ist in erster Linie vom jeweiligen Anwendungszweck abhängig; sie sollten jedoch in der Regel mehr als 80 % Wasser enthalten.

Die nachstehenden Beispiele sollen die Erfindung und ihre Anwendungsmöglichkeiten näher erläutern. Gewichtsteile (Gt) und Volumenteile (Vt) stehen im Verhältnis g/cm ; Prozentzahlen und Mengenverhältnisse sind, wenn nicht anders angegeben, in Gewichtsteilen zu verstehen.

Beispiel 1 (Vergleichsbeispiel)

22.6 Gt eines herkömmlichen Polyvinylbutyrals mit einem Molekulargewicht von etwa 70 bis 80 000, das 71 % Vinylbutyral-, 2 % Vinylacetat- und 27 % Vinylalkoholeinheiten enthält, werden in 170 Gt wasserfreiem Tetrahydrofuran gelöst. Zu der Lösung wird bei Raumtemperatur eine Mischung von 5.11 Gt Propenylsulfonylisocyanat und 30 Gt Tetrahydrofuran innerhalb 15 Minuten zugetropft. Die Lösung wird 4 Stunden bei Raumtemperatur nachgerührt und anschließend in 5 000 Gt Wasser eingetropft, wobei man ein weißes, faserloses Produkt erhält, welches abgesaugt und bis zur Gewichtskonstanz im Vakuum bei 40 °C getrocknet wird. Das Polymer besitzt eine Säurezahl von 144.

Aus 4.5 Gt dieses Polymeren, 4.5 Gt eines Mischpolymerisats aus Styrol und Maleinsäureanhydrid und 6.0 Gt 2-Vinyl-4-(2′-chlorphenyl)-5-(4′-diethylaminophenyl)-oxazol wird in 45 Gt Ethylenglykolmonomethylether, 20 Gt Butylacetat und 70 Gt Tetrahydrofuran eine Lösung hergestellt. Dieser werden als Sensibilisatoren 0.1 Gt Astrazonorange R (C.I. 48040) und 0.04 Gt Rhodamin B (C.I. 45170) zugesetzt. Die Lösung wird auf eine elektrochemisch aufgerauhte, anodisierte und mit Polyvinylphosphonsäure nachbehandelte Aluminiumfolie aufgebracht. Nach dem Verdunsten des Lösungsmittels erhält man eine Photoleiterschicht von 5.1 $g/m^2$ Schichtgewicht, mit deren Hilfe auf folgende Weise eine Druckform für den Offsetdruck hergestellt wird.

Man lädt die Schicht im Dunkeln mit Hilfe einer Corona auf -450 Volt auf und belichtet sie in einer Reprokamera bei Blende 14 12 Sekunden, wobei als Lichtquelle 10 Halogen-Strahler von je 600 W Leistung verwendet werden. Das entstandene latente Ladungsbild wird mit einem Trockentoner mit Hilfe einer Magnetwalze entwickelt. Das Tonerbild wird durch Wärmeeinwirkung fixiert. Die Photoleiterschicht kann an den nicht mit Toner bedeckten Stellen mit keiner der Lösungen folgender Zusammensetzung durch Entschichten entfernt werden:

Lösung a: 50 Gt $Na_2SiO_3$ x 9 $H_2O$ in 250 Gt Glycerin (86 %ig),
390 Gt Ethylenglykol und
310 Gt Methanol.

Lösung b: 4.0 Gt 1-Aminopropanol-2,
2.0 Gt Trinatriumcitrat,
2.0 Gt Natriumcumolsulfat,
2.5 Gt Benzylalkohol und
89.5 Gt Wasser.

Lösung c: 3.0 Gt Triethanolamin,
1.0 Gt festes KOH,
2.0 Gt Polyvinylmethylacetamid,
2.0 Gt Grahamsalz,
3.0 Gt Ethylenglykolmonophenylether,

4.0 Gt Pelargonsäure und
85.0 Gt Wasser.

Beispiel 2 (Vergleichsbeispiel)

50 Gt eines herkömmlichen Polyvinylbutyrals mit einem Molekulargewicht von etwa 70 bis 80.000, das 71 % Vinylbutyral-, 2 % Vinylacetat- und 27 % Vinylalkoholeinheiten enthält, und 4,5 Gt Maleinsäureanhydrid werden unter Erwärmen in 400 Gt Methylethylketon gelöst. Zur klaren Lösung wird 1 Gt Triethylamin hinzugefügt und die Lösung 5 Stunden zum Rückfluß erhitzt. Nach Abkühlen wird die Lösung filtriert und in 10.000 Gt Wasser eingetropft, wobei man ein weißes, faserloses Produkt erhält, welches abgesaugt und bis zur Gewichtskonstanz im Vakuum bei 40 °C getrocknet wird. Das Polymer besitzt eine Säurezahl von 42.

Aus 3.0 Gt dieses Polymeren und 2.0 Gt 2-Phenyl-4-(2′-chlorphenyl)-5-(4′-diethylaminophenyl)-oxazol wird in 18 Gt Ethylenglykolmonomethylether, 6 Gt Butylacetat und 28 Gt Tetrahydrofuran eine Lösung hergestellt. Als Sensibilisatoren werden 0.2 Gt Astrazongelb 7GLL (C.I. Basic Yellow 2) und 0.1 Gt Rhodamin FB (C.I. 45170) zugegeben. Die Lösung wird auf eine durch Drahtbürstung mechanisch oberflächlich aufgerauhte Aluminiumfolie mit einer Schichtdicke von 5 µm aufgebracht. Die Photoleiterschicht wird im Dunkeln mit Hilfe einer Corona auf etwa 450 Volt negativ aufgeladen. Die aufgeladene Photoleiterschicht wird in einer Reprokamera belichtet, wobei bei Verwendung von 8 Autophotlampen zu je 500 W die Belichtungszeit 15 Sekunden beträgt. Nach der Betonerung des durch die Belichtung entstandenen latenten Ladungsbildes mit einem handelsüblichen Toner erhält man ein saüberes, grundfreies randscharfes Bild der Vorlage, das durch Wärmeeinwirkung fixiert wird. Zur Entschichtung bringt man die betonerte Photoleiterschicht in Küvetten, die die Lösungen a, b oder c aus Beispiel 1 enthalten. Auch diese Photoleiterschicht kann mit keiner der angegebenen Lösungen entschichtet werden.

Beispiel 3 (Vergleichsbeispiel)

Mit den in Beispiel 1 eingesetzten Materialien soll in entsprechender Weise eine Druckform hergestellt werden. Lediglich die 4.5 Gt des mit Propenylsulfonylisocyanat umgesetzten Polyvinylbutyrals werden durch 4.5 Gt eines Polymerisats ersetzt, das aus demselben Polyvinylbutyral wie in Beispiel 2, jedoch durch Umsetzung mit 25 Gt Phthalsäureanhydrid statt mit Maleinsäureanhydrid hergestellt wird. Das Polymer besitzt eine Säurezahl von 91.

Die nicht mit Toner bedeckten Stellen der Druckform können mit keiner der Lösungen a, b oder c aus Beispiel 1 praxisgerecht entschichtet werden.

Beispiel 4

Mit den in Beispiel 3 eingesetzten Materialien wird in entsprechender Weise eine Druckform hergestellt. Lediglich die 4.5 Gt des mit Säuregruppen versehenen Polyvinylbutyrals werden durch 4.5 Gt eines Polymerisats ersetzt, dessen Herstellung im folgenden beschrieben wird:

20 Gt eines Pfropfpolymerisats folgender Zusammensetzung: 25 Gewichtsprozent Urethan-Gruppen im Urethanbackbone: 69.3 Gewichtsprozent Vinylalkoholeinheiten im Pfropfpolymer; Hydrolysegrad 98,9 %; Molekulargewicht: 22.000, werden in 160 Gt dest. Wasser unter leichter Wärmezufuhr gelöst. Bei Raumtemperatur werden 5.8 Gt n- Butyraldehyd und 0,08 Gt 2,6-Di-tert-.-butyl-4-methylphenol zugegeben. Zu dieser Mischung wird unter gutem Rühren eine Lösung aus 0.16 Gt Natriumocytlsulfat, 2 Gt konz. Salzsäure und 24 Gt Wasser zugetropft. Nachdem das Gemisch eine Stunde bei Raumtemperatur gerührt hat, erwärmt man auf 40 °C und rührt weitere 2 Stunden. Nach Zugabe von weiteren 5.7 Gt konz. Salzsäure wird noch zwei Stunden bei 40 °C gerührt und nach dem Abkühlen auf Raumtemperatur wird die wässrige Phase vom ausgefallenen Polymer abdekantiert, das Polymer in Ethanol gelöst, aus 10.000 Gt dest. Wasser gefällt und im Vakuumtrockenschrank bis zur Gewichtskonstanz getrocknet. 20 Gt des so hergestellten Polymeren werden in 150 Gt N-Methylpyrrolidon gelöst, mit 13.3 Gt Phthalsäureanhydrid und 0.5 Gt Triethylamin versetzt. Diese Lösung wird 6 Stunden bei 80 °C gerührt. Nach Abkühlen auf Raumtemperatur wird das Polymer aus Wasser gefällt und getrocknet. Es besitzt eine Säurezahl von 87.

Von der analog zu Beispiel 1 hergestellten Druckform (Aufladung auf - 550 Volt, Belichtung 10 Sekunden bei Blende 14) lassen sich die nicht mit Toner bedeckten Stellen mit allen in Beispiel 1 angegebenen Lösungen, auch mit den sehr milden Lösungen b und c entfernen. Trotz der geringen Säurezahl des erfindungsgemäß eingesetzten Bindemittels können somit sehr milde und toxikologisch unbedenkliche Entschichterlösungen eingesetzt werden.

Beispiel 5

Statt des in Beispiel 4 eingesetzten Bindemittels werden 4.5 Gt eines Polymerisats verwendet, das folgendermaßen hergestellt wird: 10 Gt eines Propfpolymerisats folgender Zusammensetzung: 13.1 Gewichtsprozent Urethan-Gruppen im Urethanbackbone, 58.4 Gewichtsprozent Vinylalkoholeinheiten im Pfropfpolymer; Hydrolysegrad 98.4 %; Molekulargewicht: 44.000, werden analog zu Beispiel 4, jedoch mit 7.8 Gt n-Butyraldehyd acetalisiert. Nach Lösen in Methylethylketon, Fällen aus Wasser und anschließendem Trocknen werden 12 Gt des so erhaltenen Polymerisats und 1.3 Gt Phthalsäureanhydrid in 100 Vt Methylethylketon gelöst. Die klare Lösung wird mit 0.7 Vt Triethylamin versetzt und 5 Stunden auf 80 °C erhitzt. Nach dem Ausfällen aus Wasser und Trocknen wird es als Bindemittel entsprechend Beispiel 2 eingesetzt. Obwohl die Säurezahl des Bindemittels lediglich 25 beträgt, kann die nicht mit Toner bedeckte Photoleiterschicht mit der Lösung c aus Beispiel 1 entfernt werden.

Beispiel 6

Ein weiteres Bindemittel wird aus einem Polyvinylalkohol folgender Zusammensetzung hergestellt: 14.2 Gewichtsprozent Urethan-Gruppen im Urethanbackbone, 58.9 Gewichtsprozent Vinylalkoholeinheiten im Pfropfpolymer; Hydrolysegrad 98.0 %; Molekulargewicht: 47.000. 50 Gt dieses Polymerisats werden mit n-Butyraldehyd analog zur in Beispiel 4 angeführten Vorschrift acetalisiert, so daß das Polymerisat 45.9 Gewichtsprozent Butyraleinheiten enthält.

Dieses Bindemittel wird analog zu Beispiel 4 verarbeitet. Die tonerfreien Stellen der Druckform können auch in diesem Fall, obwohl das zugesetzte Bindemittel eine Säurezahl von 0 aufweist, mit der in Beispiel 1 angegebenen Lösung c entfernt werden.

Beispiel 7

Aus einem Pfropfpolymerisat der Zusammensetzung aus Beispiel 4 wird durch folgende Umsetzungen ein Bindemittel hergestellt: 10 Gt eines Pfropfpolymerisats werden mit 3.9 Gt n- Butyraldehyd entsprechend der Vorschrift in Beispiel 4 acetalisiert. Das umgefällte und getrocknete Acetal wird in 80 Vt Methylethylketon aufgenommen und bei Raumtemperatur mit 3.3 Gt p-Toluolsulfonylisocyanat in 10 Vt Methylethylketon tropfenweise versetzt. Als Katalysator werden 2 Tropfen Dibutylzinndilaurat zugegeben. Die Lösung wird zwei Stunden bei Raumtemperatur und vier Stunden bei 60 °C gerührt. Das aus Wasser gefällte und getrocknete Polymerisat besitzt eine Säurezahl von 51.

Entsprechend Beispiel 2 wird eine Druckform hergestellt. Als Bindemittel werden 3.0 Gt des oben beschriebenen Polymerisats eingesetzt. Von dieser Druckform werden die nicht mit Toner bedeckten Stellen mit den in Beispiel 1 angegebenen Lösungen a und c problemlos entfernt.

Beispiel 8

Aus einem Pfropfpolymerisat der Zusammensetzung analog zu Beispiel 6 wird durch eine Reaktionsfolge analog zu Beispiel 4 ein Bindemittel hergestellt. Lediglich statt der 13.3 Gt Phthalsäureanhydrid werden 16.0 Gt eingesetzt. Das aus Wasser ausgefällte und getrocknete Polymer besitzt eine Säurezahl von 39.

Mit den in Beispiel 1 eingesetzten Materialien wird in entsprechender Weise eine Druckform hergestellt. Die 4.5 Gt des Polyvinylbutyralderivats werden durch 4.5 Gt des obigen Polymerisats ersetzt. Die nicht mit Tone bedeckten Stellen der Druckform lassen sich problemlos mit allen drei Lösungen a, b und c aus Beispiel 1 entfernen.

Beispiel 9

Analog zu Beispiel 4 wird ein Bindemittel hergestellt. Es werden jedoch 7.8 Gt n-Butyraldehyd und 4.5 Gt Phthalsäureanhydrid zur Synthese eingesetzt. Das umgefällte und getrocknete Polymer besitzt eine Säurezahl von 42.

Mit den in Beispiel 2 verwendeten Materialien, wobei die 3.0 Gt des dort verwendeten Polyvinylbutyrals mit Säuregruppen durch obiges Pfropfpolymerisat ersetzt werden, wird eine Druckform hergestellt. Obwohl beide Bindemittel eine Säurezahl von 42 besitzen, unterscheiden sich die bebilderten Platten sehr stark in der Entschichtbarkeit der tonerfreien Stellen. Die hier hergestellte Druckform kann mit den in Beispiel 1 angeführten Lösungen a, b und c entschichtet werden, während die Schichten aus Beispiel 2 mit keiner dieser Lösungen zu entfernen sind.

Beispiel 10

Analog zu Beispiel 4 wird ein Bindemittel synthetisiert. Es werden 7.5 Gt n-Butyraldehyd und 4.4 Gt Maleinsäureanhydrid zu den Umsetzungen verwendet. Das gefällte und getrocknete Polymer besitzt eine Säurezahl von 65.

Dieses Polymerisat wird in eine Beschichtungslösung analog zu Beispiel 1, anstatt des Polyvinylbutyrals eingesetzt. Von den tonerfreien Stellen der mit dieser Lösung hergestellten Druckform kann mit den Lösungen a und c die Photoleiterschicht abgelöst werden.

Beispiel 11

Analog zu Beispiel 4, jedoch mit 4.5 Gt Bernsteinsäureanhydrid wird ein Bindemittel mit der Säurezahl 58 synthetisiert.

4.5 Gt dieses Polymerisats werden in die Rezeptur von Beispiel 1 anstatt des dort verwendeten Polyvinylbutyrals eingearbeitet. Die tonerfreie Photoleiterschicht der entsprechend Beispiel 1 hergestellten Druckform kann mit den Lösungen a, b und c aus Beispiel 1 vom Träger entfernt werden.

Beispiel 12 (Vergleichsbeispiel)

Aus 8 Gt 2,5-Bis-(4′-N,N-diethylaminophenyl)-1,3,4-oxdiazol, 12 Gt eines Copolymerisats aus Styrol und Maleinsäureanhydrid, 0.10 Gt Astrazonorange G (C.I. 48035) und 0.05 Gt Brillantgrün (C.I. 42040) in 52 Gt Tetrahydrofuran wird eine Lösung hergestellt, die auf eine 50 μm dicke Polyethylenterephthalatfolie mit einer Trockenschichtstärke von 30 μm beschichtet wird. Die Schicht ist sehr spröde und zeigt schon bei geringer Durchbiegung der Trägerfolie deutliche Risse. Biegt man die Schicht um einen Zylinder mit einem Radius 15 cm, beginnt sie abzuplatzen. Die photoleitfähige Schicht ist nicht laminierbar. Das Material ist zur Herstellung eines Leiterplattenresists nicht einsetzbar.

Beispiel 13 (Vergleichsbeispiel)

Entsprechend Beispiel 12, jedoch mit einem Terpolymer aus 30 % Methacrylsäure, 10 % Styrol und 60 % Methacrylsäureester als Bindemittel, wird eine Polyethylenterephthalatfolie beschichtet. Auch diese Schicht erweist sich als sehr spröde und sie beginnt schon beim Trocknen von der Trägerfolie abzuplatzen. Das Material ist für einen flexiblen elektrophotographischen Leiterplattenresist nicht einsetzbar.

Beispiel 14

Entsprechend Beispiel 12, jedoch statt des Copolymerisats mit einem aus einem Pfropfpolyvinylalkohol folgender Zusammensetzung durch Acetalisierung analog zu Beispiel 4 hergestellten Bindemittel: 25 Gewichtsprozent Urethangruppen im Urethanbackbone, 52.7 Gewichtsprozent Vinylalkoholeinheiten im Pfropfpolymerisat; Hydrolysegrad 98.9 %; Molekulargewicht: 14.000, wird eine Polyethylenterephthalatfolie beschichtet. Die Schicht ist sehr flexibel und kann, ohne Risse zu zeigen, um einen Zylinder von 1 cm Radius gebogen werden. Zur Herstellung einer gedruckten Schaltung wird das Material durch Laminieren bei einer Temperatur von 95 °C vom Zwischenträger auf eine Kupfer-kaschierte Epoxidharzplatte übertragen.

Beispiel 15

Entsprechend Beispiel 12 wird eine Polyesterfolie beschichtet. Als Bindemittel wird allerdings ein Polymerisat eingesetzt, das durch Acetalisierung mit 3.6 Gt n-Butyraldehyd aus 10 Gt eines Pfropfpolyvinylalkohols folgender Zusammensetzung entsprechend Beispiel 4 hergestellt wird: 10 Gt eines Polymerisats: 25.0 Gewichtsprozent Urethan-Gruppen im Polymerbackbone; 52.7 Gewichtsprozent Vinylalkoholeinheiten im Pfropfpolymer; Hydrolysegrad: 98.9 %; Molekulargewicht: 28.571. Im Anschluß an die Acetalisierung wird das umgefällte Polymer in 50 Vt Methylethylketon gelöst und tropfenweise mit einer Lösung aus 3.2 Gt Propenylsulfonylisocyanat in 15 Vt Methylethylketon versetzt. Nach 1.5 Std. Rühren bei Raumtemperatur wird das Polymer aus Wasser gefällt. Es besitzt eine Säurezahl von 63. Die beschichtete Folie ist sehr flexibel und kann, wie die Folie aus Beispiel 14, um einen Zylinder gebogen werden und auf eine kupferkaschierte Epoxidharzplatte laminiert werden. Das trotz der hohen Schichtdicke sehr lichtempfindliche photoleitfähige Aufzeichnungsmaterial wird im Dunkeln bildmäßig belichtet, betonert und der bildmäßig angelagerte Toner durch Wärmestrahlung fixiert. In einem anschließenden Verfahrensschritt werden die Teile der photoleitfähigen Schicht,

die nicht vom Toner bedeckt sind, durch Behandeln mit dem wäßrig-alkalischen Entschichter aus Beispiel 1, Lösung c, bis zur Kupferschicht weggelöst. Diese Entschichtung verläuft mit dem erfindungsgemäßen Bindemittel besonders leicht. Die weiteren Verfahrensschritte (Galvanisieren, Verzinnen, Strippen, Ätzen) werden wie in der Leiterplattentechnik üblich durchgeführt und führen zu einer qualititiv hochwertigen Leiterplatte.

Beispiel 16

Analog zu Beispiel 7 wird ein Bindemittel hergestellt. Es werden jedoch 7.8 Gt n- Butyraldehyd und 8.1 Gt Propenylsulfonylisocyanat zur Synthese eingesetzt. Das umgefällte und getrocknete Polymer besitzt eine Säurezahl von 63.

Mit den in Beispiel 2 verwendeten Materialien, wobei die 3.0 Gt des dort verwendeten Polyvinylbutyrals mit Säuregruppen durch obiges Pfropfpolymerisat ersetzt werden, wird eine Druckform hergestellt. Die Photoleiterschicht kann mit den Lösungen a, b und c aus Beispiel 1 entfernt werden.

Beispiel 17

Aus 10 Gt des in Beispiel 2 eingesetzten Pfropfvinylalkohols wird durch Acetalisierung analog der Vorschrift in Beispiel 4 mit einem Gemisch aus 1.0 Gt 3-Hydroxy-pentanal und 2.7 Gt Iso-Butyraldehyd ein Bindemittel hergestellt, dessen OH-Zahl bei 530 liegt. Analog Beispiel 1 wird eine Beschichtungslösung angesetzt, in der die Bindemittel durch eine Mischung aus 2.25 Gt des obigen Polymerisats und 6.75 Gt eines Copolymerisats aus Styrol und Maleinsäureanhydrid ersetzt werden. Diese Lösung wird so auf den Träger aus Beispiel 1 aufgebracht, daß ein Trockenschichtgewicht von 5.5 $g/m^2$ erhalten wird. Nach Aufladung der Schicht und Belichtung wird das enstandene latente Ladungsbild mit einem Flüssigentwickler, wie er in der französischen Patentschrift 74 14 841 entsprechend GB-PS 1 465 926, beschrieben ist, entwickelt. Dazu dispergiert man 1.5 g eines Hochvakuumbitumens mit einem Erweichungspunkt von 130 - 140 °C in einer Lösung von 6.5 g eines Pentaerythritharzesters in 1000 Vt eines Isoparaffins mit einem Siedebereich zwischen 185 und 210 °C. Nach dem Entwickeln wird die Photoleiterschicht an den bildfreien Stellen mit Lösung c aus Beispiel 1 entfernt.

Beispiel 18

Aus 45 Gt der in Tabelle 1 aufgeführten Polymerisate, 45 Gt eines Mischpolymerisats aus Styrol und Maleinsäureanhydrid, 60 Gt 2-Phenyl-4-(2′-chlor-phenyl)-5-(4′-diethylaminophenyl)-oxazol, 0.8 Gt Astrazonorange G (C.I. 48035) und 0.3 Gt Rhodamin FB (C.I. 45170) in 200 Gt Butylacetat, 700 Gt Tetrahydrofuran und 450 Gt Ethylenglykolmonomethylether werden Beschichtungslösungen hergestellt und auf einen elektrochemisch aufgerauhten, anodisierten und mit Polyvinylphosphonsäure behandelten Alumniumträger so aufgebracht, daß ein Trockenschichtgewicht von 5.5 $g/m^2$ erhalten wird. Die Platten werden mit einer Gorona auf ein Oberflächenpotential von ca. -550 Volt aufgeladen. Nach dem Abschalten der Corona verbleibt die Platte für 60 Sekunden im Dunkeln. Der beobachtete prozentuale Potentialabfall (bezogen auf das ursprüngliche Potential) wird angegeben als Dunkelentladung. Die Hellentladung wird angegeben als Energie $E_{1/8}$, die notwendig ist, um die Photoleiterschicht auf ein Achtel des ursprünglichen Potentials zu entladen. Sie errechnet sich als Produkt aus der Zeit, nach der die Aufladung auf ein Achtel abgefallen ist und der Lichtintensität I der Lampe, mit der die Probe belichtet wird (Xenophot HLX, Glühfadenbirne der Firma Osram).

Tabelle 1

| Nr. | Polymerisat aus Beispiel Nr. | Dunkelentladung in % nach 60 Sekunden | Hellentladung $E_{1/8}$ (J/cm²) |
|---|---|---|---|
| 1 | 1 V | 21 | 158 |
| 2 | 2 V | 19 | 156 |
| 3 | 3 V | 26 | 147 |
| 4 | 4 | 23 | 142 |
| 5 | 6 | 16 | 139 |
| 6 | 8 | 21 | 140 |
| 7 | 9 | 18 | 153 |
| 8 | 11 | 18 | 152 |
| 9 | Copolymerisat Styrol-Maleinsäureanhydrid | 22 | 175 |

Die erfindungsgemäßen Bindemittel unterstützen offensichtlich den Ladungstransport durch die elektrophotographische Schicht beim Belichten bei gleichzeitig niedriger Dunkelentladung.

Beispiel 19

Es werden die Materialien aus Beispiel 8 eingesetzt und damit eine Druckform hergestellt, mit dem Unterschied daß das Trockenschichtgewicht nur 3 g/m² beträgt. Das Material wird im Dunkeln auf -550 Volt aufgeladen, bildmäßig belichtet, betonert und der Toner an den Bildstellen durch Wärmestrahlung fixiert. Man erhält trotz der geringen Schichtdicke ein kontrastreiches, gut deckendes Tonerbild. In dem anschließenden Verfahrensschritt werden die Teile der photoleitfähigen Schicht, die nicht von Toner bedeckt sind, durch Behandeln mit Lösung c aus Beispiel 1 vollständig weggelöst.

**Patentansprüche**

1. Elektrophotographisches Aufzeichnungsmaterial aus einem elektrisch leitenden, insbesondere zur Herstellung von Druckformen oder gedruckten Schaltungen geeigneten Schichtträger und einer photoleitfähigen Schicht, die Photoleiter, alkalilösliches Bindemittel, Sensibilisator und/oder Aktivator und übliche Zusätze enthält, dadurch gekennzeichnet, daß als Bindemittel ein Pfropfmischpolymerisat mit einem Polyurethan als Pfropfgrundlage mit aufgepfropften Ketten vorhanden ist, die Vinylalkoholeinheiten enthalten.

2. Aufzeichnungsmaterial nach Anspruch 1, dadurch gekennzeichnet, daß die aufgepfropften Ketten ferner Vinylestereinheiten enthalten.

3. Aufzeichnungsmaterial nach Anspruch 1 oder 2, dadurch gekennzeichnet, daß die aufgepfropften Ketten

ferner Vinylacetaleinheiten enthalten.

4. Aufzeichnungsmaterial nach Anspruch 3, dadurch gekennzeichnet, daß die Vinylacetaleinheiten von einem aliphatischen oder cycloaliphatischen Aldehyd abgeleitet sind.

5. Aufzeichnungsmaterial nach Ansprüchen 1 bis 4, dadurch gekennzeichnet, daß die aufgepfropften Ketten ferner Einheiten von weiteren ethylenisch ungesättigten, mit Vinylestern copolymerisierbaren Monomeren enthalten.

6. Aufzeichnungsmaterial nach Ansprüchen 1 bis 5, dadurch gekennzeichnet, daß die aufgepfropften Ketten Carboxylgruppen enthalten.

7. Aufzeichnungsmaterial nach Ansprüchen 1 bis 6, dadurch gekennzeichnet, daß die aufgepfropften Ketten Sulfonylurethangruppen enthalten.

8. Aufzeichnungsmaterial nach Anspruch 1, dadurch gekennzeichnet, daß das Polyurethan ein Polyadditionsprodukt aus Diisocyanaten und Diolen ist.

9. Aufzeichnungsmaterial nach Anspruch 8, dadurch gekennzeichnet, daß als Diol ein aliphatisches Diol mit 2 bis 12 Kohlenstoffatomen, ein cycloaliphatisches Diol mit 5 bis 10 Kohlenstoffatomen oder ein aliphatisches Polydiol mit einem Molekulargewicht von 200 bis 10.000 eingesetzt wird.

10. Aufzeichnungsmaterial nach Anspruch 9, dadurch gekennzeichnet, daß als Diol ein Gemisch aus 1 mol Polydiol und 0,1 bis 0,7 mol niedermolekularem aliphatischem Diol eingesetzt wird.

11. Aufzeichnungsmaterial nach Anspruch 8, dadurch gekennzeichnet, daß das Diisocyanat ein aliphatisches Diisocyanat mit 4 bis 15 Kohlenstoffatomen oder ein cycloaliphatisches Diisocyanat mit 7 bis 15 Kohlenstoffatomen ist.

12. Aufzeichnungsmaterial nach Ansprüchen 1 bis 11, dadurch gekennzeichnet, daß das Bindemittel 10 bis 80 Molprozent freie Hydroxylgruppen, 1 bis 65 Molprozent Acylgruppen, 0 bis 85 Molprozent Acetalgruppen, 0 bis 40 Molprozent Carboxylgruppen und 0 bis 40 Molprozent Sulfonylurethangruppen enthält.

13. Aufzeichnungsmaterial nach Ansprüchen 1 bis 12, dadurch gekennzeichnet, daß es in der photoleitfähigen Schicht 80 bis 40 Gewichtsprozent an Pfropfmischpolymerisat als Bindemittel enthält.

14. Aufzeichnungsmaterial nach Ansprüchen 1 bis 13, dadurch gekennzeichnet, daß in der photoleitfähigen Schicht ein Bindemittelgemisch vorhanden ist, das zu 10 Gewichtsprozent aus Pfropfmischpolymerisat besteht.

15. Aufzeichnungsmaterial nach Anspruch 1, dadurch gekennzeichnet, daß es mindestens einen organischen Photoleiter enthält.

16. Aufzeichnungsmaterial nach Ansprüchen 1 und 15, dadurch gekennzeichnet, daß es mindestens einen Sensibilisierungsfarbstoff enthält.

## Claims

1. An electrophotographic copying material composed of an electrically conducting film base suitable, in particular, for producing a printing form or a printed circuit, and of a photoconductive film which contains photoconductor, alkali-soluble binder, sensitizer and/or activator and standard additives, wherein a graft copolymer having a polyurethane as grafting base with grafted-on chains which contain vinyl alcohol units is present as binder.

2. The copying material as claimed in claim 1, wherein the grafted-on chains furthermore contain vinyl ester units.

3. The copying material as claimed in claim 1 or 2, wherein the grafted-on chains furthermore contain vinyl acetal units.

4. The copying material as claimed in claim 3, wherein the vinyl acetal units are derived from an aliphatic or cycloaliphatic aldehyde.

5. The copying material as claimed in claims 1 to 4, wherein the grafted-on chains furthermore contain units of further ethylenically unsaturated monomers which can be copolymerized with vinyl esters.

6. The copying material as claimed in claims 1 to 5, wherein the grafted-on chains contain carboxyl groups.

7. The copying material as claimed in claims 1 to 6, wherein the grafted-on chains contain sulfonylurethane groups.

8. The copying material as claimed in claim 1, wherein the polyurethane is a polyaddition product of diisocyanates and diols.

9. The copying material as claimed in claim 8, wherein an aliphatic diol containing 2 to 12 carbon atoms, a cyclo-aliphatic diol containing 5 to 10 carbon atoms or an aliphatic polydiol having a molecular weight of 200 to 10,000 is used as diol.

10. The copying material as claimed in claim 9, wherein a mixture of 1 mol of polydiol and 0.1 to 0.7 mol of low-molecular-weight aliphatic diol is used as diol.

11. The copying material as claimed in claim 8, wherein the diisocyanate is an aliphatic diisocyanate containing 4 to 15 carbon atoms or a cycloaliphatic diisocyanate containing 7 to 15 carbon atoms.

12. The copying material as claimed in claims 1 to 11, wherein the binder contains 10 to 80 mol percent of free hydroxyl groups, 1 to 65 mol percent of acyl groups, 0 to 85 mol percent of acetal groups, 0 to 40 mol percent of carboxyl groups and 0 to 40 mol percent of sulfonylurethane groups.

13. The copying material as claimed in claims 1 to 12, which contains 80 to 40 percent by weight of graft copolymer as binder in the photoconductive film.

14. The copying material as claimed in claims 1 to 13, wherein a binder mixture which is composed of up to 10 percent by weight of graft copolymer is present in the photoconductive film.

15. The copying material as claimed in claim 1, which contains at least one organic photoconductor.

16. The copying material as claimed in claims 1 and 15, which contains at least one sensitizing dye.

## Revendications

1. Matériau de reproduction électrophotographique composé d'un support de couche conducteur de l'électricité, approprié en particulier à la fabrication de formes d'impression ou de circuits imprimés, et d'une couche photoconductrice qui contient un photoconducteur, un liant soluble dans des solutions alcalines, un sensibilisateur et/ou un activateur et des additifs usuels, caractérisé en ce que, en tant que liant, est présent un copolymère greffé comportant un polyuréthanne en tant que support de greffe, avec des chaînes greffées qui contiennent des motifs alcool vinylique.

2. Matériau de reproduction selon la revendication 1, caractérisé en ce que les chaînes greffées contiennent en outre des motifs ester vinylique.

3. Matériau de reproduction selon la revendication 1 ou 2, caractérisé en ce que les chaînes greffées contiennent en outre des motifs acétal de vinyle.

4. Matériau de reproduction selon la revendication 3, caractérisé en ce que les motifs acétal de vinyle dérivent d'un aldéhyde aliphatique ou cycloaliphatique.

5. Matériau de reproduction selon les revendications 1 à 4, caractérisé en ce que les chaînes greffées contiennent en outre des motifs d'autres monomères à insaturation éthylénique, copolymérisables avec des esters vinyliques.

6. Matériau de reproduction selon les revendications 1 à 5, caractérisé en ce que les chaînes greffées contiennent des groupes carboxy.

7. Matériau de reproduction selon les revendications 1 à 6, caractérisé en ce que les chaînes greffées contiennent des groupes sulfonyluréthanne.

8. Matériau de reproduction selon la revendication 1, caractérisé en ce que le polyuréthanne est un produit de polyaddition de diisocyanates et de diols.

9. Matériau de reproduction selon la revendication 8, caractérisé en ce que, en tant que diol, on utilise un diol aliphatique ayant de 2 à 12 atomes de carbone, un diol cycloaliphatique ayant de 5 à 10 atomes de carbone ou un polydiol aliphatique ayant une masse moléculaire de 200 à 10 000.

10. Matériau de reproduction selon la revendication 9, caractérisé en ce que, en tant que diol, on utilise un mélange de 1 mole de polydiol et de 0,1 à 0,7 mole d'un diol aliphatique à faible masse moléculaire.

11. Matériau de reproduction selon la revendication 8, caractérisé en ce que le diisocyanate est un diisocyanate aliphatique ayant de 4 à 15 atomes de carbone ou un diisocyanate cycloaliphatique ayant de 7 à 15 atomes de carbone.

12. Matériau de reproduction selon les revendications 1 à 11, caractérisé en ce que le liant contient 10 à 80 % en moles de groupes hydroxy libres, 1 à 65 % en moles de groupes acyle, 0 à 85 % en moles de groupes acétal, 0 à 40 % en moles de groupes carboxy et 0 à 40 % en moles de groupes sulfonyluréthanne.

13. Matériau de reproduction selon les revendications 1 à 12, caractérisé en ce qu'il contient en tant que liant, dans la couche photoconductrice, 80 à 40 % en poids d'un copolymère greffé.

14. Matériau de reproduction selon les revendications 1 à 13, caractérisé en ce que, dans la couche photoconductrice, est présent un mélange de liants qui consiste, à raison de 10 % en poids, en un copolymère greffé.

15. Matériau de reproduction selon la revendication 1, caractérisé en ce qu'il contient au moins un photoconducteur organique.

16. Matériau de reproduction selon les revendications 1 à 15, caractérisé en ce qu'il contient au moins un colorant sensibilisateur.